(19)

Europäisches
Patentamt

European
Patent Office

Office européen
des brevets

(11) **EP 3 754 368 A1**

(12) **EUROPEAN PATENT APPLICATION**

(43) Date of publication:
**23.12.2020 Bulletin 2020/52**

(51) Int Cl.:
**G01S 7/486** (2020.01)     **G01S 17/10** (2020.01)
**H03F 3/08** (2006.01)

(21) Application number: **19181159.5**

(22) Date of filing: **19.06.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Integrated Device Technology, Inc.
San Jose, CA 95138 (US)**

(72) Inventors:
 • **SCHIAPPELLI, Fulvio
  81479 München (DE)**

 • **GRUBER, Dominik
  80997 München (DE)**
 • **TAVANO, Giuseppe
  80992 München (DE)**
 • **GREITSCHUS, Norbert
  79346 Endingen (DE)**

(74) Representative: **Lippert Stachow Patentanwälte
Rechtsanwälte
Partnerschaft mbB
Krenkelstraße 3
01309 Dresden (DE)**

(54) **AMPLIFIER SYSTEM AND METHOD FOR OPERATING AN AMPLIFIER SYSTEM, PARTICULARLY FOR AN OPTICAL RECEIVER SYSTEM OF A LIGHT DETECTION AND RANGING SYSTEM**

(57)     The invention relates to an amplifier system (1), particularly for an optical receiver system of a light detection and ranging system, comprising:
an input (3) for a signal of an optical receiver (2),
an amplifier (4) for amplifying the signal ($I_{IN}$) of the optical receiver (2),
a comparator (5) for comparing the input signal ($V_C$) with a target reference value ($V_{REF}$), and
a current source (6) for providing a current ($I_C$) to the input (2),
wherein if the amplifier system (1) detects that no signal ($I_{IN}$) of the optical receiver (3) is provided at the input (2), particularly that the signal ($I_{IN}$) of the optical receiver (3) at the input (2) has ended, the comparator (5) compares the present input value ($V_C$) with the target reference value ($V_{REF}$) and if the present input value ($V_C$) differs from the target reference value ($V_{REF}$) the amplifier system (1) provides the current ($I_C$) to the input (2) using the current source (6) until the present value ($V_C$) corresponds to the target reference value ($V_{REF}$).

The invention further relates to a method for operating an amplifier system (1), particularly for an optical receiver system of a light detection and ranging system.

Fig. 3

EP 3 754 368 A1

**Description**

The invention relates to an amplifier system, particularly for an optical receiver system of a light detection and ranging system. The invention further relates to a method for operating an amplifier system, particularly for an optical receiver system of a light detection and ranging system.

Optical receiver systems are for example used in light detection and ranging (Lidar) systems, also called laser detection and ranging (Ladar) systems. Such systems measure the distance to a target by illuminating the target with pulsed laser light and measuring the reflected pulses with an optical sensor. Differences in laser return times and wavelength can then be used to make 3-D representations of the target. Lidar systems have become popular in automotive applications, for example in advanced safety systems. A lidar systems is for example used to scan the surroundings of a car to detect any obstacles on a collision course with the car and issue a warning to the driver and/or to initiate an emergency brake. Lidar systems are often used in autonomous cars for controlling and navigation purposes. In such automotive applications it is essential that the Lidar systems is highly available and precise with a minimum of detection errors.

The optical receiver system usually comprises a string of optical receivers, which are for example arranged in the front part of an automobile. The string of optical receivers is connected to a solid-state optical receiver driver system, for processing the signals of the optical receivers. For example, the solid-state optical receiver driver system is arranged inside the automobile and connected to the string of optical receivers via a cable. The solid-state optical receiver driver system comprises at least one optical receiver channel, which is connectable to a respective optical receiver. Usually the solid-state optical receiver driver system comprises a separate optical receiver channel for each optical receiver of the optical receiver system.

The optical receiver system amplifies the signal of the optical receiver before processing the optical receiver signal. The amplified optical receiver signal is usually converted from the analog domain to the digital domain by an analog-to-digital converter and afterwards being processed by a digital signal processor. Therefore, each optical receiver channel comprises a separate amplifier system for amplifying the respective optical receiver signals.

If a signal of the optical receiver is too intense, the amplifier system output saturates to its negative value before recovering. A disadvantage of the known amplifier systems is that these can permanently stuck at saturation if a train of closely in time spaced pulses with amplitudes high enough to saturate the amplifier system is received by the optical receiver.

It is therefore an object of the invention to provide an amplifier system, particularly for an optical receiver system of a light detection and ranging system, that can process a closely in time space train of pulses with high amplitudes.

The object is solved by an amplifier system, particularly for an optical receiver system of a light detection and ranging system, comprising:

an input for a signal of an optical receiver,

an amplifier for amplifying the signal of the optical receiver,

a comparator for comparing the input signal to a target reference value, and

a current source for providing a current to the input,

wherein if the amplifier system detects that no signal of the optical receiver is provided at the input, particularly that the signal from the optical receiver at the input has ended, the comparator compares the present input value with the target reference value and if the present input value differs from the target reference value the amplifier system provides a current to the input using the current source until the present input value corresponds to the target reference value.

The target reference value corresponds to an optimal input value, i.e. with no input signal and no previous amplifier saturation. This value is also referred to as reference voltage $V_{REF}$.

If the amplifier system detects that no input signal is present at the input, particularly that the signal from the optical receiver at the input has ended, the comparator compares the present input value with the target reference value. If both values are equal no further actions are required. If the present input differs from the target reference value the amplifier system provides a current to the input until the present input value corresponds to the target reference value. The amplifier system uses the current source for providing the current. By providing a current to the input the present input value faster recovers to the target reference value and the amplifier system can process a train pulse with high amplitudes at a faster rate than the amplifier system of the prior art.

The amplifier system can detect that the signal from the optical receiver has ended by detecting the falling edge of the signal pulse generated by the optical receiver.

In a variant of the invention the input is connected to or comprises a filter, in particular a resistor-capacitance filter, particularly a high-pass filter. As long as a signal is provided to the input the capacitor of the filter charges. Once the input signal is no longer present, the capacitor discharges via the resistor, causing a change of polarity at the input of the amplifier system. The time constant for discharging the capacitor is defined by:

$$T = R * C,$$

wherein R is in Ω and C in Farads.

This change of polarity can be used by the amplifier system to detect if a signal or no signal is provided at the input, particularly that the signal from the optical receiver at the input has ended. If no signal is provided at the input respectively the signal from the optical receiver at the input has ended and the present input value differs from the target reference value, the amplifier system provides a current to the input using the current source. This current accelerates the discharging of the capacitor and the input faster recovers to the target reference value for processing the next input signal.

Pursuant to a variant of the invention the amplifier system further comprises a first switch for disconnecting the amplifier from the input if the amplifier system detects that no signal of the optical receiver is provided at the input, particularly that the signal from the optical receiver at the input has ended, and the comparator detects that the present input value does not correspond to the target reference value. In this way the current provided to the input cannot flow to the amplifier.

According to a further variant of the invention the amplifier system further comprises a reference voltage source for providing the target reference value, particularly an adjustable reference voltage source. In this way the amplifier system can be used with respect to different light detection and ranging systems because the amplifier system can be adjusted to the light detection and ranging system. Particularly the reference voltage source is a replica of the amplifier. The replica provides a reference voltage for the comparator that has the exact value present at the input of the input of the amplifier with no signal from the optical receiver. In this way, the capacitor can be charged up exactly to that value. At this value the comparator toggles and the amplifier input is restored to the steady state.

In an advantageous variant of the invention the amplifier system further comprises a second switch for disconnecting the comparator from the input if a signal of the optical receiver is provided to the input and/or if no input signal of the optical receiver is provided at the input and the present input value corresponds to the target reference value. Thus, the comparator is connected to the input after the signal of the optical receiver vanished and the comparator is directly disconnected if the current input corresponds to the target reference value. In this way the comparator does not negatively affect the input of the amplifier system. After the next input signal is no longer present at the input, the amplifier system can again connect the comparator to the input by the second switch to compare the input with the target reference value. Thus, the comparator is only connected to and affecting the input if no signal of the optical receiver is present at the input, particularly if the signal from the optical receiver at the input has ended.

Pursuant to another variant of the invention the amplifier system comprises a third switch for connecting and disconnecting the current source to the input. The current source is only connected to the input of the amplifier system if there is no signal from the optical receiver present at the input, particularly if the signal from the optical receiver at the input has ended, and the present input differs from the target reference value. The current source therefore does not negatively affect the signal of the optical receiver.

Advantageously the comparator, the amplifier and/or the reference voltage source comprises an operational amplifier. This is an easy and cheap way to build the components on a semiconductor die or to integrate the components in a circuit.

According to a particularly preferred variant of the invention the amplifier is a transimpedance amplifier. A transimpedance amplifier converts an input current to a proportional output voltage. The ratio of output voltage to input current is called the transimpedance of the amplifier. Using such a transimpedance amplifier it is possible to measure very small input currents accurately.

In a further variant of the invention the optical receiver is a photodetector like a photodiode.

Pursuant to a further variant the amplifier system comprises an analog-to-digital converter, for converting the output signal of the amplifier to a digital signal. The amplifier system can further comprise a buffer between the amplifier and the analog-to-digital converter, for buffering the output of the amplifier before converting the output signal to the digital domain. In either variant, the amplifier system can further comprise a digital signal processor for processing the signals of the analog-to-digital converter.

According to a preferred variant the amplifier system comprises multiple channels for multiple optical receivers. Each channel of the amplifier system can comprise an input, amplifier, comparator and a current source. However, it is also possible that one current source is used for multiple channels. Thus, the amplifier system comprises multiple inputs, amplifiers, comparators and/or current sources.

Advantageously the amplifier system further comprises a control unit for controlling the operation of the amplifier system. Particularly the control unit can monitor the input and check if a signal of an optical receiver is present at the input, particularly if the signal from the optical receiver at the input has ended. The control unit can e.g. further control the switches between the input and the amplifier, comparator and/or current source.

Pursuant to a variant of the invention the amplifier system is located on a single semiconductor die or integrated in a single circuit. In this way the amplifier system can be easily and cheap manufactured and easily integrated into a light detection and ranging system e.g. for automotive applications.

The object is further solved by a method for operating an amplifier system, particularly for an optical receiver system of a light detection and ranging system, comprising the steps of:

detecting the signals of an optical receiver at an input of the amplifier system,

comparing the input signal with a target reference value if no signal of the optical receiver is detected at the input of the amplifier system, particularly if the signal from the optical receiver at the input has ended,

providing a current to the input of the amplifier system if the input signal differs from the target reference value.

The target reference value corresponds to an optimal input value, i.e. with no input signal and no previous amplifier saturation.

If an input signal is present at the input of the amplifier system, i.e. the amplifier system is receiving a signal from the optical receiver, the input signal is amplified for further processing.

If the amplifier system is not receiving an input signal from the optical receiver, particularly if the signal from the optical receiver at the input has ended, the present input signal is compared with the target reference value. If the present input signal corresponds to the target reference value no further action is required. However, if the present input signal differs from the target reference value a current is provided to the input of the amplifier system. Due to this current the input signal of the amplifier system recovers to the target reference value faster than without the provided current.

The method can detect that the signal from the optical receiver has ended by detecting the falling edge of the signal pulse generated by the optical receiver.In a preferred variant of the invention the method comprises the step of filtering the signal of the optical receiver, particularly using a high-pass filter, like a resistor-capacitance filter. The filter eliminates low-frequency noise of the input signal, particularly a DC component. Using e. g. a resistor-capacitance filter, the capacitor will charge up as long as the input signal is present at the input of the amplifier system. Once the input signal is no longer present, the capacitor will start to discharge, causing a change in polarity of the present signal at the input of the amplifier system. This change of polarity can be used by the amplifier system to detect if no signal of the optical receiver is present at the input. The current provided to the input causes a faster discharging of the capacitor, so that the signal at the input of the amplifier system faster recovers to the target reference value.

Pursuant to a variant of the invention the method comprises the step of disconnecting an amplifier of the amplifier system from the input if no signal of the optical receiver is detected at the input of the amplifier system, particularly if the signal from the optical receiver at the input has ended, and if the input of the amplifier system differs from the target reference value. Thus, at times where a current is provided to the input to recover the signal at the input to target reference value the amplifier of the amplifier system is disconnected from the input, so that the provided current is not amplified by the amplifier.

According to a variant of the invention the target reference value is provided by a reference voltage source. This voltage reference source can be adjustable to use the amplifier system with different optical receiver system of different light detection and ranging system. Particularly, the reference voltage source uses a replica of the amplifier of the amplifier system to produce the target reference value.

In a variant of the method according to the invention the current source is disconnected from the input of the amplifier system if no current is provided to the input of the amplifier system. In this way, the current source does not affect the signal processing of the amplifier system, particularly the processing of the signal of the optical receiver.

Pursuant to a variant of the invention the method comprises the step of converting the amplified input signal to a digital signal. The digital signal can be easier processed afterwards. The method can comprise the further step of buffering the amplified input signal before converting the amplified signal to the digital signal.

Preferably the method comprises the step of digitally processing the digital signal, e.g. by a digital signal processor. The digital signal processor can easily and fast perform the processing of the signal. Furthermore, the processed signal can be forwarded digitally to the light detection and ranging system.

Advantageously, multiple input signals are processed in parallel. Therefore, the amplifier system can comprise multiple channels, wherein each channel for example comprises an input, an amplifier, a comparator and/or a current source. Usually a light detection and ranging system comprises a string of optical receivers, like photodetectors, particularly photodiodes, for receiving a light signal reflected or scattered from an object in the surroundings of the light detection and ranging system. The signals of the separate optical receivers of the string of optical receivers are processed by the separate channels of the amplifier system in parallel.

In the following the invention will be further explained with respect to the embodiments shown in the figures. It shows:

Fig. 1      a block diagram of an amplifier system according to the prior art,

Fig. 2      voltage diagrams at different points of the amplifier system according to Fig. 1,

Fig. 3      a block diagram of an amplifier system according to the invention,

Fig. 4     voltage diagrams at different points of the amplifier system according to Fig. 3.

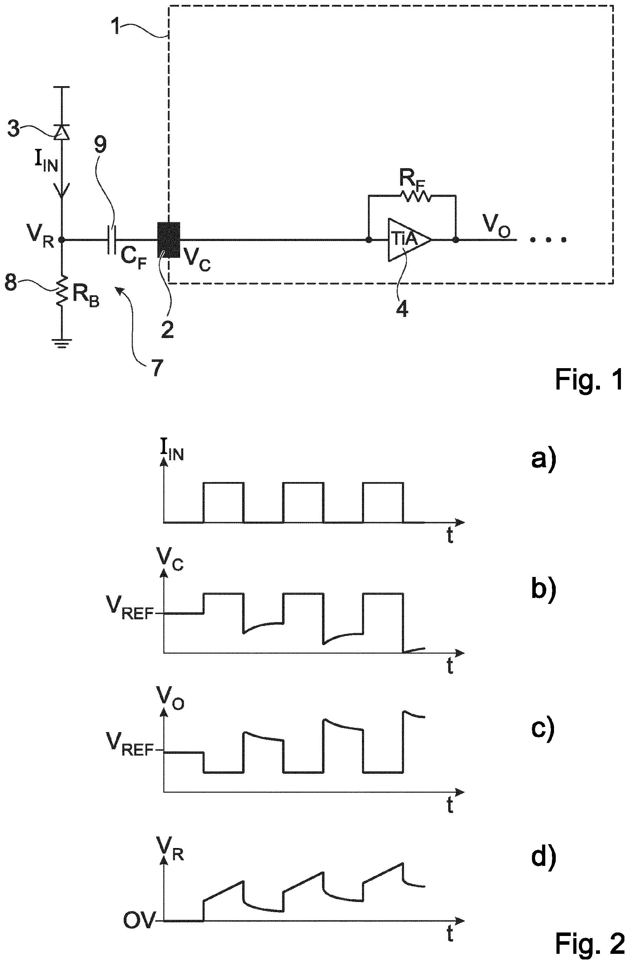

Fig. 1 shows a block diagram of an amplifier system 1 according to the prior art. The amplifier system 1 is particularly used for an optical receiver system of a light detection and ranging system.

A light detection and ranging system sends out a short light pulse, particularly a laser pulse, to the surroundings of the light detection and ranging system, using a light source, particularly a laser source. Special optics can be used to bundle and/or direct the light pulse.

The light pulse eventually hits one or more targets in the surroundings of the light detection and ranging system. The light pulse is reflected and/or scattered back from the one or more targets.

The reflected and/or back scattered light is received by an optical receiver system of the light detection and ranging system. The optical receiver system can comprise receiver optics for bundling and/or directing the received light. An optical receiver 3, particularly a photodetector like a photodiode, is used to detect the received light. The optical receiver 3 converts the received light to a corresponding current $I_{IN}$.

Advantageously the signal $V_R$ of the optical receiver 3 is filtered by a filter 7, particularly a high-pass filter to supress any DC components of the received signal.

The received and filtered signal $V_C$ of the optical receiver 3 is forwarded to an input 2 of an amplifier system 1 of the optical receiver system. The amplifier system 1 amplifies the received and filtered signal $V_C$ using an amplifier 4.

The amplified signal $V_O$ is for example converted from the analog domain to the digital domain for further processing by a digital signal processor.

Usually a light detection and ranging system at least comprises multiple optical receivers 3 and corresponding multiple amplifier systems 1. The multiple optical receivers 3 are used to detect the angle and/or strength distribution of the received light signal.

From the signal strength distribution and/or angle of the received light signal the light detection and ranging system can calculate the position and shape of targets in the surroundings of the light detection and ranging system.

Fig. 2 shows voltage diagrams at different points of the amplifier system according to Fig. 1. For example, the optical receiver 3 generates the current pulses $I_{IN}$ according to Fig. 2a. Thus, optical receiver 3 receives light pulses in regular intervals.

At the input 2 of the amplifier system the voltages $V_C$ according to Fig. 2b can be observed. The working point of the amplifier system 1 is at $V_{REF}$. Once the optical receiver 3 receives a light signal, the input signal $V_C$ increases. Once no light signal is received from the optical receiver 3 the signal $V_C$ at the input 2 of amplifier system 1 drops. Due to the capacitor 9 next to the input 2 the signal $V_C$ drops below $V_{REF}$.

Assuming that the capacitor 9 does not completely discharge until the next light signal is received by the optical receiver 3 the capacitor 9 will further charge up because of the next light signals.

Fig. 2c shows the output $V_O$ of the amplifier 4 of the amplifier system 1. Due to the charging of the capacitor 9 and especially due to the uncomplete discharging of the capacitor 9 during the light signal pauses, the amplifier 4 generates each time as stronger signal $V_O$, although the amplitude of the received light signal at the optical receiver 3 is not changing. At some point, the amplifier 4 is always saturated and the signal $V_O$ at the output $V_O$ does not all corresponds to the signal of the optical receiver 3.

The signal $V_R$ between the optical receiver 3 and the capacitor 9 is shown in Fig. 2d. Like the output signal $V_O$ of the amplifier 4, the voltage level $V_R$ is also increasing with each light signal pulse because the capacitor 9 does not completely discharge.

One solution to this problem would be to amend the emitted light pulses, especially by increasing the light pauses. However, this would negatively affect the accuracy and sampling rate of the light detection and ranging system, which is not acceptable for some applications, especially for automobile applications.

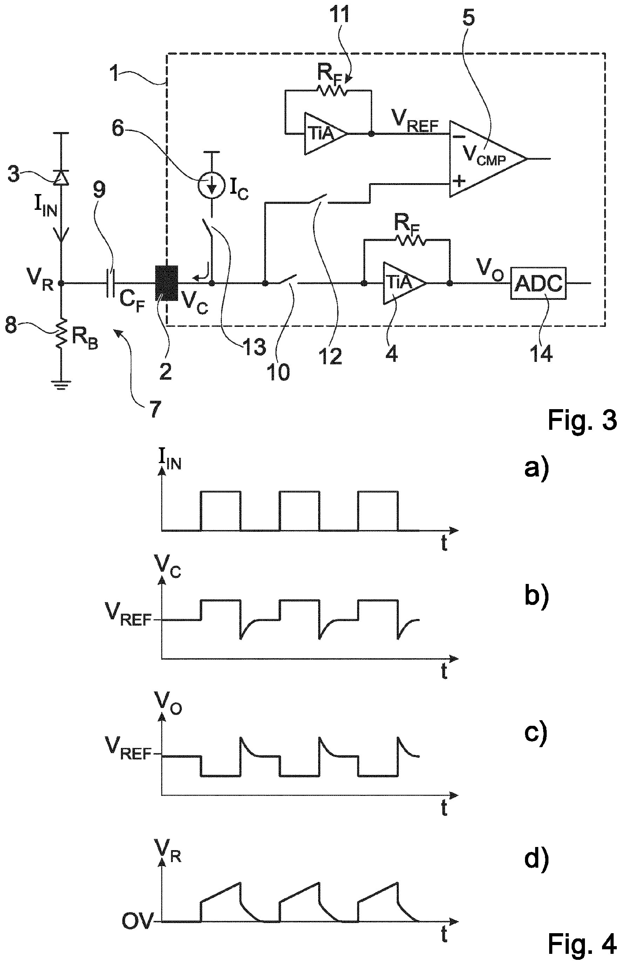

Fig. 3 shows a block diagram of an amplifier system 1 according to the invention. In addition to the amplifier system 1 of the prior art shown in Fig. 1 the amplifier system 1 according to the invention further comprises a comparator 5 for comparing the input signal $V_C$ with the target reference value $V_{REF}$ and a current source 6 for providing a current $I_C$ to input 2.

If the amplifier system 1 detects that no signal of the optical receiver 3 is provided at the input 2, particularly if the signal from the optical receiver 3 has ended, the comparator 5 compares the present input value $V_C$ with the target reference value $V_{REF}$ and if the present input value $V_C$ differs from the target reference value $V_{REF}$ the amplifier system 1 provides the current $I_C$ to the input 2 using the current source 6 until the present input value $V_C$ corresponds to the target reference value $V_{REF}$.

The current $I_C$ of the current source 6 causes a much faster discharging of the capacitor 9, so that a train of pulses with shorter intervals can be correctly processed by the amplifier system 1 according to the invention.

The amplifier system 1 comprises a first switch 10 for disconnecting the amplifier 4 from the input 2 if the amplifier system 1 detects that no signal $I_{IN}$ of the optical receiver 3 is provided at the input 2, particularly that the signal $I_{IN}$ from the optical receiver 3 has ended, and the comparator 5 detects that the present input value $V_C$ does not correspond to the target reference value $V_{REF}$. In this case a current $I_C$ is provided to the input 2 by current source 6 and to avoid that this current $I_C$, i.e. a signal at the input of the amplifier 4, is amplified by the amplifier 4, the amplifier is disconnected from the input 2 by the first switch 10.

By opening the first switch 10 the voltage $V_R$ immediately drops to 0 V, although VR is not accessible by the amplifier system 1, and the voltage across the capacitor 9 appears at input 2 of the amplifier system 1, thus defining the input voltage of the amplifier system $V_C$.

The target reference value $V_{REF}$ is provided by a reference voltage source 11, which can be a replica of the amplifier 4.

The amplifier system 1 of Fig. 3 further comprises a second switch 12 for disconnecting the comparator 5 from the input 2 if a signal $I_{IN}$ of the optical receiver 3 is provided to the input 2 and/or if no signal $I_{IN}$ of the optical receiver 3 is provided at the input 2, respectively the signal $I_{IN}$ of the optical receiver 3 at the input 2 has ended, and the present input value $V_C$ corresponds to the target reference value $V_{REF}$.

The amplifier system 1 according to Fig. 3 comprises a third switch 13 for connecting and disconnecting the current source 6 to the input 2.

According to Fig. 3 the amplifier 4, the reference voltage source 11 and the comparator 5 each comprise an operational amplifier.

Amplifier 4 is a transimpedance amplifier, i.e. it converts an input current to a proportional output voltage $V_O$. The optical receiver 3 is a photodetector like a photodiode. The amplifier system 1 further comprises an analog-to-digital converter 14 for converting the analog signal $V_O$ to a digital signal, which is e.g. processed by a digital signal processor (not shown).

Although Fig. 3 only shows one channel, the amplifier system 1 can comprises multiple channels for processing the signals of multiple optical receivers 3 in parallel. For example, each channel of the amplifier system 1 can comprise a filter 7, an input 2, a current source 6, an amplifier 4, a comparator 5, a reference voltage source 11, first to third switches 10, 12, 13 and/or analog-to-digital converter 14. If possible, one or more of these components can also be shared by the channels of the amplifier system 1

The amplifier system 1 detects the signals $I_{IN}$ of the optical receiver 3 at the input 2. If no signal $I_{IN}$ of the optical receiver 3 is present at the input 2, particularly if the signal $I_{IN}$ of the optical receiver 3 at the input 2 has ended, the present input signal $V_C$ is compared to a target reference value $V_{REF}$. A current $I_C$ is provided if the present input $V_C$ differs from the target reference value $V_{REF}$.

If a current $I_C$ is provided to the input 2, the amplifier 4 is disconnected from the input 2 by the first switch 10.

The current source 6 is disconnected from the input 2 if no current $I_C$ is provided to the input 2 by the third switch 13.

The comparator 5 is connected to the input 2 if the input signal $I_{IN}$ vanishes, so that the comparator 5 can compare the present input value $V_C$ with the target reference value $V_{REF}$. If the present input value $V_C$ corresponds to the target reference value $V_{REF}$ the comparator 5 is disconnected from the input 2 again.

Fig. 4 shows voltage diagrams at different points of the amplifier system according to Fig. 3. The diagrams correspond to the voltage diagrams of Fig. 2.

The difference between the voltage diagrams of Fig. 2 (prior art) and Fig. 4 (invention) is that the peaks in Fig. 4b, 4c, 4d caused by the capacitor 9 of filter 7 much faster return to the target reference value $V_{REF}$ respectively 0 V. This is due to the current $I_C$ provided to the input 2 by current source 6.

Therefore, the amplifier system 1 can process a train of pulses with shorter intervals, particularly pulse pauses, from the optical receiver 3. The risk of a permanent saturation of the amplifier 4 is accordingly minimized.

**List of reference numerals**

| | |
|---|---|
| 1 | amplifier system |
| 2 | input |
| 3 | optical receiver |
| 4 | amplifier |
| 5 | comparator |
| 6 | current source |
| 7 | filter |
| 8 | resistor |
| 9 | capacitor |
| 10 | first switch |
| 11 | reference voltage source |
| 12 | second switch |
| 13 | third switch |
| 14 | analog-to-digital converter |
| $V_{REF}$ | target reference voltage |
| $I_{IN}$ | input current optical receiver |
| $V_R$ | voltage optical receiver |
| $V_C$ | input voltage amplifier system |
| $V_O$ | output voltage amplifier |
| $V_{CMP}$ | output voltage comparator |

**Claims**

1. Amplifier system (1), particularly for an optical receiver system of a light detection and ranging system, comprising:

> an input (3) for a signal of an optical receiver (2),
> an amplifier (4) for amplifying the signal ($I_{IN}$) of the optical receiver (2),
> a comparator (5) for comparing the input signal ($V_C$) with a target reference value ($V_{REF}$), and
> a current source (6) for providing a current ($I_C$) to the input (2),

wherein if the amplifier system (1) detects that no signal ($I_{IN}$) of the optical receiver (3) is provided at the input (2), particularly that the signal ($I_{IN}$) of the optical receiver (3) at the input (2) has ended, the comparator (5) compares the present input value ($V_C$) with the target reference value ($V_{REF}$) and if the present input value ($V_C$) differs from the target reference value ($V_{REF}$) the amplifier system (1) provides the current ($I_C$) to the input (2) using the current source (6) until the present input value ($V_C$) corresponds to the target reference value ($V_{REF}$).

2. Amplifier system (1) according to claim 1, wherein the input (2) is connected to or comprises a filter (7), particularly a highpass filter, in particular a resistor-capacitance filter.

3. Amplifier system (1) according to claim 1 or claim 2, further comprising a first switch (10) for disconnecting the amplifier (4) from the input (2) if the amplifier system (1) detects that no signal ($I_{IN}$) of the optical receiver (3) is provided at the input (2), particularly if the signal ($I_{IN}$) of the optical receiver (3) at the input (2)has ended, and the comparator (5) detects that the present input value ($V_C$) does not correspond to the target reference value ($V_{REF}$).

4. Amplifier system (1) according to any of claims 1 to 3, further comprising a reference voltage source (11) for providing the target reference value ($V_{REF}$), wherein the reference voltage source (11) particularly is a replica of the amplifier (4).

5. Amplifier system (1) according to any of claims 1 to 4, further comprising a second switch (12) for disconnecting the comparator (5) from the input (2) if a signal ($I_{IN}$) of the optical receiver (3) is provided to the input (2) and/or if no signal ($I_{IN}$) of the optical receiver (3) is provided at the input (2), particularly if the signal ($I_{IN}$) of the optical receiver (3) at the input (2)has ended, and the present input value ($V_C$) corresponds to the target reference value ($V_{REF}$).

6. Amplifier system (1) according to any of claims 1 to 5, further comprising a third switch (13) for connecting and disconnecting the current source (6) to the input (2) .

7. Amplifier system (1) according to any of claims 1 to 6, further comprising an analog-to-digital converter (14).

8. Amplifier system (1) according to any of claims 1 to 7, wherein the amplifier system (1) comprises multiple channels for multiple optical receivers (3), particularly multiple inputs (2), amplifiers (4), comparators (5) and/or current sources (6).

9. Method for operating an amplifier system (1), particularly for an optical receiver system of a light detection and ranging system, comprising the steps of:

   detecting the signals ($I_{IN}$) of an optical receiver (3) at an input (2) of the amplifier system (1),
   comparing the input signal ($V_C$) with a target reference value ($V_{REF}$) if no signal ($I_{IN}$) of the optical receiver (3) is detected at the input (2) of the amplifier system (1), particularly if the signal ($I_{IN}$) of the optical receiver (3) at the input (2)has ended, and
   providing a current ($I_C$) to the input (2) of the amplifier system (1) if the input signal ($V_C$) differs from the target reference value ($V_{REF}$).

10. Method for operating an amplifier system (1) according to claim 9, comprising the step of filtering the signal ($I_{IN}$) of the optical receiver (3), particularly using a high-pass filter, like a resistor-capacitance filter.

11. Method for operating an amplifier system (1) according to claim 9 or claim 10, further comprising the step of disconnecting an amplifier (4) of the amplifier system (1) from the input (2) if no signal ($I_{IN}$) of the optical receiver (3) is detected at the input (2) of the amplifier system (1), particularly if the signal ($I_{IN}$) of the optical receiver (3) at the input (2)has ended, and the present input value ($V_C$) differs from the target reference value ($V_{REF}$).

12. Method for operating an amplifier system (1) according to any of claims 9 to 11, further comprising the step of disconnecting the current source (6) from the input (2) of the amplifier system (1) if no current ($I_C$) is provided to the input (2) of the amplifier system (1).

13. Method for operating an amplifier system (1) according to any of claims 9 to 12, further comprising the step of converting the amplified input signal to a digital domain.

14. Method for operating an amplifier system (1) according to claim 13, further comprising the step of buffering the amplified input ($V_O$) signal before converting the amplified signal ($V_O$) to the digital domain and/or comprising the step of digitally processing the digital signal.

15. Method for operating an amplifier system (1) according to any of claims 9 to 14, wherein multiple input signals are processed in parallel.

Fig. 1

a)

b)

c)

d)

Fig. 2

Fig. 3

a)

b)

c)

d)

Fig. 4

**Europäisches Patentamt**
**European Patent Office**
**Office européen des brevets**

# EUROPEAN SEARCH REPORT

Application Number

EP 19 18 1159

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/018092 A1 (KING BRIAN J [US]) 25 January 2007 (2007-01-25) * paragraphs [0024], [0031]; figure 3 * ----- | 1-15 | INV. G01S7/486 G01S17/10 H03F3/08 |
| X | US 2016/377745 A1 (DAERR HEINER [DE] ET AL) 29 December 2016 (2016-12-29) * paragraph [0101] - paragraph [0112]; figures 6, 7, 9 * ----- | 1-15 | |

TECHNICAL FIELDS
SEARCHED        (IPC)

G01S
H03F

The present search report has been drawn up for all claims

| Place of search | Date of completion of the search | Examiner |
|---|---|---|
| Munich | 20 November 2019 | Beer, Mark |

EPO FORM 1503 03.82 (P04C01)

## ANNEX TO THE EUROPEAN SEARCH REPORT
## ON EUROPEAN PATENT APPLICATION NO.

EP 19 18 1159

This annex lists the patent family members relating to the patent documents cited in the above-mentioned European search report.
The members are as contained in the European Patent Office EDP file on
The European Patent Office is in no way liable for these particulars which are merely given for the purpose of information.

20-11-2019

| Patent document cited in search report | Publication date | Patent family member(s) | Publication date |
|---|---|---|---|
| US 2007018092 A1 | 25-01-2007 | NONE | |
| US 2016377745 A1 | 29-12-2016 | CN 105793734 A | 20-07-2016 |
| | | EP 3074791 A1 | 05-10-2016 |
| | | JP 6209683 B2 | 04-10-2017 |
| | | JP 2016540208 A | 22-12-2016 |
| | | US 2016377745 A1 | 29-12-2016 |
| | | WO 2015078753 A1 | 04-06-2015 |

EPO FORM P0459

For more details about this annex : see Official Journal of the European Patent Office, No. 12/82